# EUROPÄISCHE PATENTSCHRIFT

(11) **EP 2 992 736 B1**
(45) Veröffentlichungstag und Bekanntmachung des Hinweises auf die Patenterteilung: **12.02.2020**
(21) Anmeldenummer: 14731539.4
(22) Anmeldetag: 30.04.2014
(51) Int. Cl.: H05B 33/08, H02M 3/337, H02M 1/00

(54) **VERFAHREN ZUM BETREIBEN EINES LED-KONVERTERS**
METHOD FOR OPERATING AN LED CONVERTER
PROCÉDÉ POUR FAIRE FONCTIONNER UN CONVERTISSEUR LED

(30) Priorität: 30.04.2013 AT 1552013 U
(43) Veröffentlichungstag der Anmeldung: 09.03.2016
(73) Patentinhaber: Tridonic GmbH & Co KG, 6851 Dornbirn (AT)
(72) Erfinder: VONACH, Christoph, 6850 Dornbirn (AT)
(74) Vertreter: Rupp, Christian
(86) Internationale Anmeldenummer: PCT/AT2014/000098
(87) Internationale Veröffentlichungsnummer: WO 2014/176611

(56) Entgegenhaltungen:
- EP-A2- 2 252 133
- WO-A2-2009/116025
- WO-A2-2011/113951
- CN-Y- 2 914 480
- DE-A1-102009 030 106
- US-A1- 2009 273 292
- US-A1- 2011 080 102
- US-A1- 2012 025 720
- US-B1- 6 344 979

## Beschreibung

Die Erfindung betrifft einen Wandler zur Versorgung eines Leuchtmittels, einen LED-Konverter und ein Verfahren zum Betreiben eines derartigen Wandlers. Die Erfindung betrifft insbesondere derartige Vorrichtungen und Verfahren, bei denen ein Leuchtmittel, insbesondere ein Leuchtmittel, das ein oder mehrere Leuchtdioden umfasst, mit einem so genannten SELV ("Separated Extra-Low Voltage" oder "Safety Extra-Low Voltage")-Gerät mit Energie versorgt wird.

Wandler mit Potentialtrennung dienen zur galvanisch entkoppelten Übertragung von elektrischer Energie von einer Eingangsseite zu einer Ausgangsseite. Derartige Wandler werden in verschiedenen Anwendungen zur Strom- oder Spannungsversorgung, wie beispielsweise in getakteten Schaltnetzteilen, eingesetzt. Bei getakteten Wandlern werden steuerbare Schalter, die in Form von Leistungsschaltern ausgestaltet sein können, verwendet und getaktet betrieben, um elektrische Energie auf die Ausgangsseite zu übertragen. Eine galvanisch entkoppelte Energieübertragung kann durch Verwendung eines Transformators oder anderen Übertragers erzielt werden. Eine derartige galvanische Trennung bzw. Potentialtrennung wird aus Sicherheitsgründen bei Betriebsgeräten für Leuchtmittel gefordert, um einen ELV ("Extra-Low Voltage")-Bereich durch eine so genannte Potentialbarriere oder SELV-Barriere von Bereichen mit höherer Versorgungsspannung, insbesondere Netzspannung, zu trennen.

Zum Betreiben von Leuchtmitteln können Wandler eingesetzt werden, die als so genannte Resonanzwandler ausgestaltet sind, die einen Resonanzkreis aufweisen. Der Resonanzkreis kann ein Serien- oder Parallelresonanzkreis sein. Bei der Ausgestaltung von Wandlern besteht das Ziel, Verluste gering zu halten. Bei Wandlern, die für den Betrieb dimmbarer Leuchtmittel, insbesondere von Leuchtdioden (LEDs) wie anorganische LEDs oder organische LEDs (OLEDs), geeignet sein sollen, besteht zunehmend die Anforderung, eine Dimmbarkeit über einen weiten Bereich zu ermöglichen.

Resonanzwandler, die einen LLC-Resonanzkreis mit zwei Induktivitäten und einer Kapazität umfassen, können primärseitig resonant oder quasi-resonant gesteuert werden. Derartige Wandler haben den Vorteil, dass ein energieeffizienter Betrieb mit relativ geringen Schaltverlusten möglich ist.

Aus Sicherheitsgründen soll der Betrieb eines Wandlers erlauben, zumindest bestimmte Betriebszustände, beispielsweise Leerlauf oder Kurzschluss am Ausgang des SELV-Bereichs, zu erkennen. Darüber hinaus ist die Erfassung der Ausgangsspannung wünschenswert, um eine Last, die mit dem Ausgang des Wandlers verbunden ist, zu erkennen. Ein herkömmlicher Ansatz verwendet hierzu eine direkte Messung der Ausgangsspannung, die in der sekundär-seitigen Schaltung durchgeführt wird. Die auf der Sekundärseite erfasste Spannung kann dann über einen Isolator zur Primärseite rückgeführt wird. Die Überbrückung der SELV-Barriere erfordert entsprechende Komponenten, die Bauraum und/oder Kosten des Betriebsgeräts erhöhen.

Die folgenden Druckschriften des Standes der Technik offenbaren weitere Hintergrundinformationen für die vorliegende Erfindung:
**D1** = EP 2 252 133 A2 (OSRAM GMBH [DE]) 17. November 2010 (2010-11-17)
**D2** = DE 10 2009 030106 A1 (MINEBEA CO LTD [JP]) 23. Dezember 2010 (2010-12-23)
**D3** = US 2011/080102 A1 (GE LIANGAN [CN] ET AL) 7. April 2011 (2011-04-07)
**D4** = WO 2009/116025 A2 (POWERMAT LTD [IL]; AZANCOT YOSSI [IL]; BEN SHALOM AMIR [IL]; GREENWALD) 24. September 2009 (2009-09-24)
**D5** = US 2009/273292 A1 (ZIMMERMANN MICHAEL [CH]) 5. November 2009 (2009-11-05)
**D6** = US 2012/025720 A1 (CHEN FAN [CN] ET AL) 2. Februar 2012 (2012-02-02)
**D7** = WO 2011/113951 A2 (TRIDONIC AG [CH]; TRIDONIC GMBH & CO KG [AT]; ZIMMERMANN MICHAEL [CH];) 22. September 2011 (2011-09-22)

In den Druckschriften D1, D2 und D3 ist offenbart, dass eine Spannung im Primärkreis eines Transformators ausgewertet werden kann, um Rückschlüsse auf Betriebszustände im Sekundärkreis des Transformators zu ziehen. Auf der Primärseite des Transformators ist ein LLC-Serienresonanzkreis vorgesehen, der über eine Halbbrückenschaltung getaktet wird. Die Druckschrift D4 offenbart ebenfalls eine Auswertung der Spannung im Primärkreis eines Transformators.

Die Druckschrift US 6,344,979 B1 offenbart einen DC/DC-Wandler mit einem LLC-Serienresonanzkreis und die Druckschrift CN 2 914 480 Y offenbart einen schaltbaren Leistungswandler.

Es besteht ein Bedarf an Vorrichtungen und Verfahren, die Verbesserungen im Hinblick auf die genannten Ziele bieten. Insbesondere besteht ein Bedarf an Vorrichtungen und Verfahren, bei denen der schaltungstechnische Aufwand und/oder die Kosten, die bei herkömmlichen Vorrichtungen zum Überbrücken der SELV-Barriere verbunden sind, reduziert oder vermieden werden können. Es besteht auch ein Bedarf an derartigen Vorrichtungen und Verfahren, die eine effiziente Energieübertragung und Dimmbarkeit über einen weiten Bereich erlauben.

Erfindungsgemäß wird ein Verfahren zur Bestimmung der Streuinduktivität eines Transformators eines LLC-Resonanzwandlers für ein Leuchtmittel mit den im Anspruch 1 angegebenen Verfahrensschritten angegeben.

Nach der Erfindung wird ein LLC-Resonanzwandler, der eine primärseitige, getaktet betriebene Halbbrückenschaltung und einen LLC-Resonanzkreis umfasst, so betrieben, dass primärseitig eine Spannung erfasst wird, die mit der Streuinduktivtät des LLC-Resonanzwandlers korreliert ist.

Die Erifndung betrifft ein Verfahren zur Bestimmung der Streuinduktivität eines Transformators (28, 29) eines LLC-Resonanzwandlers (19; 49; 69; 79; 89) für ein Leuchtmittel (3; 5),
wobei der LLC-Resonanzwandler (19; 49; 69; 79; 89) eine primärseitige Schaltung (20; 50; 70; 80; 90) und eine davon galvanisch getrennte sekundärseitige Schaltung (30) aufweist,
wobei der Transformator eine Primärspule (28) und eine Sekundärspule (29) aufweist,
wobei die primärseitige Schaltung (20; 50; 70; 80; 90) des LLC-Resonanzwandlers (19; 49; 69; 79; 89) eine mit dem Transformator verbundene LLC-Resonanzschaltung und eine mit der LLC-Serienresonanzschaltung verbundene Halbbrückenschaltung (21, 22) aufweist,
wobei das Verfahren umfasst:
a) Aus dem Ruhezustand des LLC-Resonanzwandlers (19, 49; 69; 79; 89) heraus, Einschalten eines ersten Schalters (21) der Halbbrückenschaltung (21, 22);
b) Erfassen einer Spannung an einem Messwiderstand (RS) in Serie zu der Primärspule (28) des Transformators (28, 29); und
c) Verarbeiten, in einer Steuereinrichtung (14), der erfassten Spannung, wobei das Verarbeiten ein Erfassen eines Anstiegs der erfassten Spannung über eine Zeitspanne umfasst, die von dem Überschreiten (start) einer unteren Referenzspannung (Vrefu) bis zum Erreichen (stop) einer oberen Referenzspannung (Vrefo) zur Bestimmung der Streuinduktivität ausgewertet wird.

Nach einem Ausführungsbeispiel wird ein Verfahren zur Bestimmung der Streuinduktivität des Transformators eines LLC-Resonanzwandlers für ein Leuchtmittel angegeben. Der LLC-Resonanzwandler weist eine primärseitige Schaltung und eine davon galvanisch getrennte sekundärseitige Schaltung auf. Ein erster Schalter und ein zweiter Schalter werden in einer Halbbrückenschaltung, mit der ein LLC-Resonanzkreis der primärseitigen Schaltung verbunden ist, getaktet geschaltet. Eine Spannung wird in der primärseitigen Schaltung erfasst.

Der Wandler kann als FCC-Gerät ("Fixed Constant Current", fixierter Konstantstrom), als Gerät mit einstellbaren Konstantstrom (dimmbares Gerät mit abhängig vom Dimmwert einstellbarer Stromamplitude), als FCV-Gerät ("Fixed Constant Voltage", fixierte Konstantspannung) oder als Gerät mit einstellbarer Konstantsspannung (dimmbares Gerät mit abhängig vom Dimmwert einstellbarer Spannungsamplitude) ausgebildet sein. Der Wandler kann als ein Gerät mit galvanischer Trennung zwischen dem SELV-Bereich und dem Nicht-SELV-Bereich ausgestaltet sein.

Der LLC-Resonanzwandler kann eine Steuereinrichtung umfassen, die die in der primärseitigen Schaltung erfasste Spannung verarbeitet. Energie zum Betreiben der Steuereinrichtung kann von einem Transformator geliefert werden, der auch Energie zwischen der primärseitigen Schaltung und der sekundärseitigen Schaltung überträgt. Eine Versorgungsschaltung kann zwischen den Transformator und die Steuereinrichtung geschaltet sein. Die Versorgungsschaltung kann mit wenigstens einer Wicklung auf dem Transformatorkern des Transformators gekoppelt sein, um eine Versorgungsspannung für die Steuereinrichtung zu erzeugen, die kleiner als eine Versorgungsspannung der primärseitigen Schaltung ist. Die Steuereinrichtung kann als integrierte Halbleiterschaltung ausgestaltet sein. Die Spannung, die mit der Ausgangsspannung der LLC-Resonanzwandlers korreliert ist, kann in der Versorgungsschaltung auf der Primärseite des Wandlers erfasst werden. Die entsprechende Spannung kann so um einen Spannungs-Offset verschoben werden, dass die nach einem Schaltvorgang der Halbbrücke auftretende Peakspannung einem positiven Spannungswert entspricht. Dadurch kann die genaue Messung der Peakspannung erleichtert werden. Zur Erzeugung des Spannungs-Offsets kann eine Konstantstromquelle und ein Widerstand verwendet werden. Der Konstantstrom kann von einem Anschluss der Steuereinrichtung geliefert werden. Der Konstantstrom kann auch von einer externen Schaltung erzeugt werden, d.h. von einer von der Steuereinrichtung verschiedenen Konstantstromquelle geliefert werden.

Die in der primärseitigen Schaltung erfasste Spannung kann an einer Primärspule eines Transformators erfasst werden. Die in der primärseitigen Schaltung erfasste Spannung kann an einem Kondensator des LLC-Resonanzkreises erfasst werden.

Nach einem Beispiel wird ein Wandler für ein Leuchtmittel angegeben. Der Wandler umfasst eine primärseitige Schaltung mit einer Halbbrückenschaltung, die zwei wechselseitig getaktete Schalter aufweist, und mit einem LLC-Resonanzkreis, der mit einem Knoten zwischen den zwei Schaltern gekoppelt ist. Der Wandler umfasst eine sekundärseitige Schaltung mit einem Ausgang zur Energieversorgung des Leuchtmittels. Die primärseitige Schaltung ist eingerichtet, um eine in der primärseitigen Schaltung erfasste Spannung, die von einer Ausgangsspannung der sekundärseitigen Schaltung abhängt, an eine Steuereinrichtung bereitzustellen. Die primärseitige Schaltung kann einen entsprechenden Anschluss zum Abgreifen der Spannung, die mit der der sekundärseitigen Schaltung korreliert ist, aufweisen.

Der Wandler kann eine Steuereinrichtung umfassen, die mit der primärseitigen Schaltung gekoppelt und eingerichtet ist, um die in der primärseitigen Schaltung erfasste Spannung zu verarbeiten, um eine Ausgangsspannung der sekundärseitigen Schaltung zu detektieren.

Ausgestaltungen des Wandlers nach vorteilhaften oder bevorzugten Beispielen sowie die damit jeweils erzielten Wirkungen entsprechen den unter Bezugnahme auf das Verfahren beschriebenen Ausgestaltungen.

Nach einem weiteren Aspekt der Erfindung wird ein Wandler für ein Leuchtmittel angegeben, bei dem eine Steuereinrichtung, die insbesondere als integrierte Halbleiterschaltung ausgestaltet sein kann, von einem Transformator mit Energie versorgt wird, der die galvanisch entkoppelte Energieübertragung zwischen Eingangsseite und Ausgangsseite leistet. Der Wandler umfasst den Transformator zum Übertragen von Energie zwischen einer Eingangsseite und einer Ausgangsseite, eine Steuereinrichtung zum Steuern des Wandlers und eine Versorgungsschaltung, die eingerichtet ist, um zur Energieversorgung der Steuereinrichtung Energie von dem Transformator zu der Steuereinrichtung zu übertragen.

Der Transformator kann eine Primärspule, eine Sekundärspule und wenigstens eine Versorgungswicklung auf einem Transformatorkern aufweist. Die wenigstens eine Versorgungswicklung kann mit der Versorgungsschaltung verbunden sein.

Ein derartiger Wandler kann auch dann eingesetzt werden, wenn keine primärseitige Spannungserfassung erfolgt, um Informationen über eine Ausgangsspannung des Wandlers bzw. über die Last am Ausgang des Wandlers zu erhalten.

Im Vergleich zu herkömmlichen Ansätzen, bei denen die Versorgungsspannung für die Steuereinrichtung eines Wandlers für ein Leuchtmittel beispielsweise über einen Spannungsteiler aus der Versorgungsspannung der primärseitigen Schaltung erzeugt wird, erlaubt die Ausgestaltung des Wandlers nach diesem Aspekt der Erfindung eine Energieversorgung der Steuereinrichtung mit geringen Leistungsverlusten.

Die Eingangsseite des Wandlers kann einen LLC-Resonanzkreis und eine Halbbrücke mit zwei wechselseitig getakteten Schaltern aufweisen. Die Halbbrücke kann von der Steuereinrichtung gesteuert werden.

Nach einem weiteren Beispiel wird ein LED-Konverter bereitgestellt, der den Wandler nach einem Beispiel umfasst.

Nach einem weiteren Beispiel wird ein Beleuchtungssystem angegeben, das den LED-Konverter und ein damit gekoppeltes Leuchtmittel umfasst. Das Leuchtmittel kann ein oder mehrere Leuchtdioden (LEDs) umfassen.

Die LEDs können anorganische und/oder organische LEDs umfassen. Die LEDs können in ein LED-Modul integriert sein, das separat von dem LED-Konverter ausgeführt ist. Das Beleuchtungssystem kann weiterhin eine zentrale Steuerung umfassen, die eingerichtet ist, um Dimmbefehle an den LED-Konverter zu übermitteln.

Die Erfindung wird nachfolgend unter Bezugnahme auf die beigefügte Zeichnung näher erläutert.
FIG. 1 zeigt eine schematische Darstellung eines Beleuchtungssystems mit einem LED-Konverter nach einem Beispiel.
FIG. 2 zeigt ein Schaltbild eines Wandlers nach einem Beispiel.
FIG. 3 illustriert die primärseitige Erfassung einer Spannung, um Informationen über eine Ausgangsspannung am Ausgang des Wandlers zu erhalten.
FIG. 4 zeigt ein Schaltbild eines Wandlers nach einem weiteren Beispiel.
FIG. 5 ist ein Flussdiagramm eines Verfahrens nach Beispiel.
FIG. 6 zeigt ein Schaltbild eines Wandlers nach einem weiteren, Beispiel.
FIG. 7 illustriert die primärseitige Erfassung einer Spannung in dem Wandler von FIG. 6, um Informationen über eine Ausgangsspannung am Ausgang des Wandlers zu erhalten.
FIG. 8 zeigt ein Schaltbild eines Wandlers nach einem weiteren, Beispiel.
FIG. 9 illustriert die primärseitige Erfassung einer Spannung in dem Wandler von FIG. 8, um Informationen über eine Ausgangsspannung am Ausgang des Wandlers zu erhalten.
FIG. 10 zeigt ein Schaltbild eines Wandlers nach einem weiteren Beispiel.
FIG. 11 zeigt ein Schaltbild eines Wandlers nach einem bevorzugten Ausführungsbeispiel.

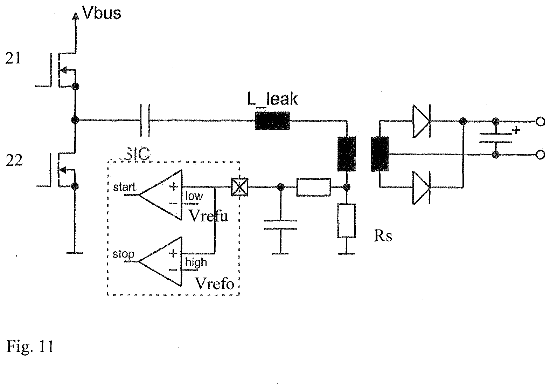

FIG. 11 zeigt einen LLC-Resonanzwandler. Anhand dieser Figur soll kurz dass Verfahren zur Bestimmung der Streuinduktivität des Transformator eines LLC-Resonanzwandlers sowie das entsprechende Betriebsgerät 2 beschrieben werden.

Die Erfindung betrifft ein Verfahren zur Bestimmung der Streuinduktivität des Transformator eines LLC-Resonanzwandlers (19; 49; 69; 79) für ein Leuchtmittel (3; 5), wobei der LLC-Resonanzwandler (19; 49; 69; 79) eine primärseitige Schaltung (19; 49; 69; 79) und eine davon galvanisch getrennte sekundärseitige Schaltung (30) aufweist, umfassend:
Einschalten eines ersten Schalters (21) einer Halbbrückenschaltung, mit der ein LLC-Resonanzkreis (25-27) der primärseitigen Schaltung (19; 49; 69; 79) verbunden ist;
Erfassen einer Spannung (VRs, V_sns; 43-46; 77, 78; 87, 88) in der primärseitige Schaltung (19; 49; 69; 79); und
Verarbeiten der in der primärseitigen Schaltung (19; 49; 69; 79) erfassten Spannung (VRs, V_sns; 43-46; 77, 78; 87, 88), vorzugsweise Erfassen des Anstiegs der erfassten Spannung über eine bestimmte Zeit, um eine Information über die Streuinduktivität zu erhalten.

Das Verarbeiten kann das Erfassen der Amplitude der Eingangsspannung des LLC-Resonanzwandlers (19; 49; 69; 79) umfassen.

Zur Erfassung der Information über die Streuinduktivität kann die Zeitspanne von dem Überschreiten einer unteren Referenzspannung (Vrefu) bis zum Erreichens einer oberen Referenzspannung (Vrefo) ausgewertet werden.

Die erfasste Spannung kann die Spannung über einem Strommesswiderstand Rs in Serie zu der Primärwicklung des Transformators des LLC-Resonanzwandlers sein.

Die Erfassung der Streuinduktivität kann durch erstmaliges Einschalten des ersten Schalters (21) aus einem Ruhezustand des LLC-Resonanzwandlers heraus erfolgen.

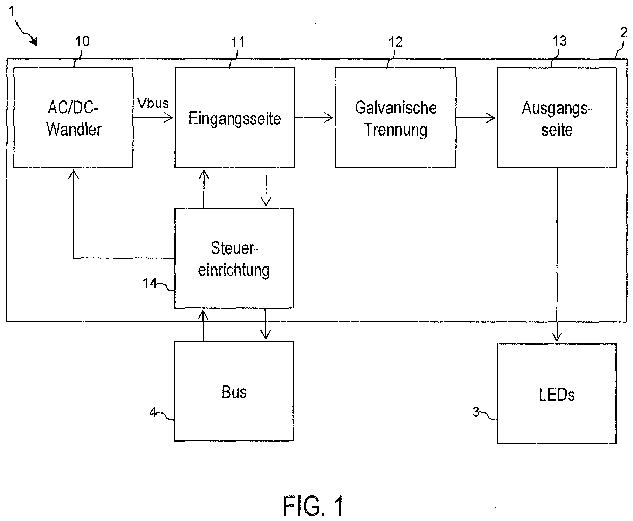

FIG. 1 zeigt ein Beleuchtungssystem 1, bei dem ein Betriebsgerät 2 nach einem Beispiel LEDs 3 mit Energie versorgt. Das Betriebsgerät 2 kann als LED-Konverter ausgestaltet sein. Der LED-Konverter 2 kann als FCC-Gerät oder FCV-Gerät ausgebildet sein. Der LED-Konverter 2 kann so ausgestaltet sein, dass die Helligkeit der LEDs 3 über Befehle, die beispielsweise über einen Bus 4 oder drahtlos übertragen werden, einstellbar ist. Der LED-Konverter 2 kann eine entsprechende Schnittstelle zur Kommunikation mit einem zentralen Steuergerät umfassen und eingerichtet sein, um über die Schnittstelle Dimmbefehle zu empfangen und um über die Schnittstelle Informationen über den Betriebszustand des LED-Konverters 2 und/oder der LEDs 3 auszugeben.

Der LED-Konverter 2 kann als SELV-Gerät ausgestaltet sein, bei der eine primärseitige Schaltung (beispielsweise eine nicht-SELV-Seite) und eine sekundärseitige Schaltung (beispielsweise eine SELV-Seite) galvanisch getrennt sind. Der LED-Konverter 2 kann einen AC/DC-Wandler 10 umfassen. Der AC/DC-Wandler 10 kann eingerichtet sein, um eingangsseitig mit einer Netzspannung gekoppelt zu werden. Der AC/DC-Wandler 10 kann als so genannte Glättungsschaltung oder Schaltung zur Leistungsfaktorkorrektur (PFC) ausgestaltet sein. Der AC/DC-Wandler 10 stellt eine Busspannung Vbus als Versorgungsspannung an einen Wandler bereit, der eine eingangs- bzw. primärseitige Schaltung 11 und eine davon galvanisch getrennte ausgangs- bzw. sekundärseitige Schaltung 13 aufweist. Eine galvanische Trennung wird durch einen Transformator 12 oder anderen Umsetzer erreicht. Der LED-Konverter 2 kann als FCC-Gerät oder FCV-Gerät ausgestaltet sein.

Der LED-Konverter 2 ist so ausgestaltet, dass eine Ausgangsspannung am Ausgang des LED-Konverters 2 basierend auf einer in der primärseitigen Schaltung 11 erfassten Spannung erkannt wird. Auf diese Weise können Fehlerzustände, beispielsweise eine offene Schaltung oder ein Kurzschluss am Ausgang, erkannt werden. Alternativ oder zusätzlich kann auch eine Last erkannt werden, die von dem LED-Konverter 2 mit Energie versorgt wird.

Zur Erkennung der Ausgangsspannung abhängig von der in der primärseitigen Schaltung erfassten Spannung ist die Steuereinrichtung 14 entsprechend mit der primärseitigen Schaltung 11 gekoppelt, um den zeitabhängigen Spannungsverlauf oder einen Peakwert der Spannung zu empfangen, die in der primärseitigen Schaltung erfasst wird. Die Steuereinrichtung 14 kann basierend auf dem Peakwert der Spannung, der nach einem Schaltvorgang von Schaltern in einer Halbbrückenschaltung der primärseitigen Schaltung 11 auftritt, Informationen über die Ausgangsspannung erhalten. Die Steuereinrichtung 14 kann so automatisch eine Fehlererkennung durchführen, um einen offenen Ausgang und/oder einen Kurzschluss zu erkennen. Die Steuereinrichtung 14 kann eine entsprechende Sicherheitsabschaltung einleiten, wenn die Peakspannung, die primärseitig nach einem Schaltvorgang von Schaltern in einer Halbbrückenschaltung auftritt, nicht in einem Intervall akzeptabler Spannungswerte für den Dauerbetrieb des LED-Konverters 2 liegt. Die Steuereinrichtung 14 kann alternativ oder zusätzlich andere Funktionen ausführen, beispielsweise eine Spannungsregelung der Ausgangsspannung abhängig von der in der primärseitigen Schaltung erfassten Spannung. Die Steuereinrichtung 14 kann auch herkömmliche Funktionen der Steuerung eines LED-Konverters, wie die Umsetzung von Dimmbefehlen ausführen.

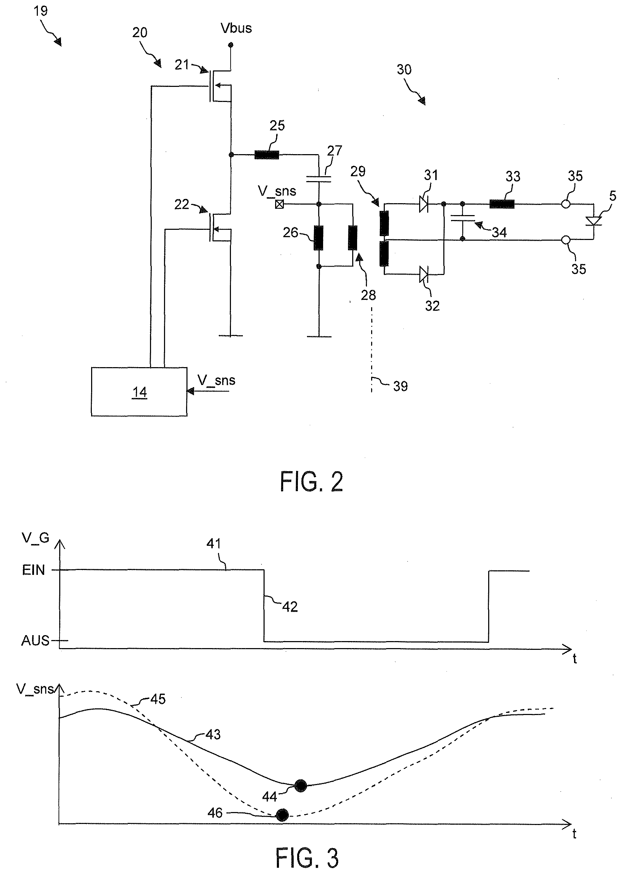

Die entsprechende Spannung in der primärseitigen Schaltung, die in direkter Beziehung zur Ausgangsspannung der sekundärseitigen Schaltung steht und aus der Informationen über die Ausgangsspannung des Wandlers ableitbar sind, kann an unterschiedlichen Stellen in der primärseitigen Schaltung abgegriffen werden, wie unter Bezugnahme auf FIG. 2-9 näher beschrieben wird.

Wie in FIG. 1 schematisch dargestellt ist, kann bei dem LED-Konverter 2 die Ausgangsspannung erkannt werden, ohne dass dafür eine Messung auf der SELV-Seite durchgeführt werden muss und/oder ohne dass ein entsprechendes Messergebnis über die SELV-Barriere zurückgeführt werden muss. Die Steuereinrichtung 14 ist so eingerichtet, dass sie abhängig von einer primärseitig gemessenen Spannung Informationen über die Ausgangsspannung des LED-Konverters 2 ableitet.

FIG. 2 ist ein Schaltbild eines Wandlers 19 nach einem Beispiel.

Der Wandler 19 umfasst eine primärseitige Schaltung 20 und eine sekundärseitige Schaltung 30. Es liegt Potentialtrennung zwischen der primärseitigen Schaltung 20 und der sekundärseitigen Schaltung 30 vor. Zur Trennung kann ein Transformator mit einer Primärspule 28 und einer Sekundärspule 29 vorgesehen sein. Der Transformator weist eine Hauptinduktivität auf, die auch als eine der Induktivitäten eines LLC-Resonanzkreises wirken kann. Diese ist in der FIG. 2 symbolisch als zweite Induktivität 26 dargestellt. Der Wandler 19 kann bei dem LED-Konverter 2 oder bei einem anderen Betriebsgerät zum Betreiben von LEDs verwendet werden, um die Funktionen der in FIG. 1 dargestellten primärseitigen Schaltung 11, der galvanischen Trennung 12 und der sekundärseitigen Schaltung 13 zu erfüllen. Der Wandler 19 wirkt als DC/DC-Wandler. Die sekundärseitige Schaltung 30 kann ein SELV-Bereich sein, der durch eine SELV-Barriere 39 vom primärseitigen Bereich getrennt ist. Die primärseitige Schaltung 20 kann alle Komponenten beinhalten, die nicht zum SELV-Bereich gehören.

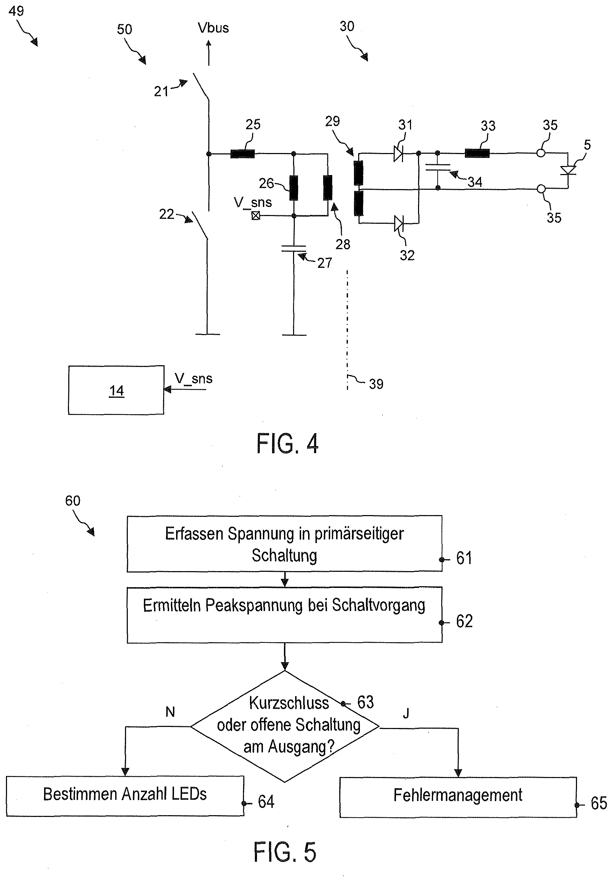

Die primärseitige Schaltung 20 umfasst einen LLC-Resonanzkreis, der als Serienresonanzkreis ausgestaltet ist. Der LLC-Resonanzkreis weist eine erste Induktivität 25, eine Kapazität 27 und eine zweite Induktivität 26 in einer Serienschaltung auf. Gemäß der allgemeinen Terminologie in diesem technischen Gebiet wird hier der Begriff "LLC-Resonanzkreis" bzw. "LLC-Resonanzwandler" so verwendet, dass damit ein Resonanzkreis mit zwei Induktivitäten und einer Kapazität bzw. ein entsprechender Wandler bezeichnet wird, wobei es nicht darauf ankommt, ob wie in FIG. 2 der Kondensator 27 zwischen die Induktivitäten 25 und 26 geschaltet ist oder ob wie in FIG. 4 die Induktivität 26 zwischen die Induktivität 25 und den Kondensator 27 geschaltet ist. Das zweite induktive Element 26 repräsentiert wie gesagt die Hauptinduktivität der Primärspule 28 des Transformators. Das zweite induktive Element 26 kann die HauptInduktivität des Resonanzkreises sein, deren Induktivität größer als die erste Induktivität 25 ist. Auch die erste Induktivität 25 kann in den Transformator integriert sein und beispielsweise eine Streuinduktivität sein. Alternativ kann auch eine zusätzliche Induktivität zusätzlich zu der Primärspule 28 des Transformators angeordnet werden und auch als eine der zwei Induktivitäten des LLC-Resonanzkreises wirken. Andere Ausgestaltungen des LLC-Resonanzkreises sind ebenfalls möglich. Beispielsweise muss die Kapazität 27 nicht zwischen die erste Induktivität 25 und die zweiten Induktivität 26 geschaltet sein.

Die primärseitige Schaltung 20 umfasst eine Halbbrückenschaltung mit einem ersten Schalter 21, der ein Leistungsschalter sein kann, und einem zweiten Schalter 22, der ein Leistungsschalter sein kann. Der erste Schalter 21 und der zweite Schalter 22 können identisch sein, und die Halbbrückenschaltung kann als symmetrische Halbbrückenschaltung ausgebildet sein. Der Resonanzkreis ist mit einem Knoten zwischen dem ersten Schalter 21 und dem zweiten Schalter 22 verbunden. Der Resonanzkreis ist mit der Mitte der Halbbrückenschaltung zwischen den zwei Schaltern 21 und 22 verbunden. Ein erster Anschluss der ersten Induktivität 25 des Resonanzkreises kann mit dem Knoten zwischen dem ersten Schalter 21 und dem zweiten Schalter 22 der Halbbrückenschaltung verbunden sein. Ein zweiter Anschluss der ersten Induktivität 25 kann mit einem ersten Anschluss der Kapazität 27 verbunden sein. Ein zweiter Anschluss der Kapazität 27 kann mit einem ersten Anschluss der zweiten Induktivität 26 des Resonanzkreises verbunden sein.

Im Betrieb des Wandlers 19 steuert die Steuereinrichtung 14 den ersten Schalter 21 und den zweiten Schalter 22. Dabei kann jeder der Schalter jeweils mit derselben vorgegebenen Frequenz ein- und ausgeschaltet werden. Die Steuereinrichtung 14 steuert den ersten Schalter 21 und den zweiten Schalter 22 so, dass immer nur einer der beiden Schalter leitend geschaltet ist. Der erste Schalter 21 und der zweite Schalter 22 werden von der Steuereinrichtung 14 wechselseitig getaktet betrieben. Die Totzeit zwischen dem Ausschalten eines Schalters und dem Einschalten des jeweils anderen Schalters kann klein sein, insbesondere viel kleiner als das Inverse der Schaltfrequenz.

Die primärseitige Schaltung 20 ist so ausgestaltet, dass eine über der Primärspule 28 abfallende Spannung erfasst werden kann. Die primärseitige Schaltung 20 kann einen entsprechenden Leiter bzw. Anschluss aufweisen, mit dem diese Spannung an die Steuereinrichtung 14 bereitgestellt werden kann.

Eine sekundärseitige Schaltung 30 weist einen der Sekundärspule 29 nachgeschalteten Gleichrichter auf, der beispielsweise durch eine erste Diode 31 und eine zweite Diode 32 gebildet sein kann. Eine Mitte der Sekundärspule 29 kann mit einem Ausgang der sekundärseitigen Schaltung gekoppelt sein. Enden der Sekundärspule 29 können über die Dioden 31 und 32 mit dem Ausgang 35 gekoppelt sein. Optional kann ein induktives Element 33, beispielsweise eine Spule, vorgesehen sein, durch das dem Ausgang 35 Strom zugeführt wird. Das induktive Element 33 kann insbesondere vorgesehen sein, wenn der Wandler 19 als FCC-Gerät betrieben werden soll. Ein Kondensator 34 kann zwischen die Ausgänge des Gleichrichters geschaltet sein.

Eine mit dem Ausgang 35 der sekundärseitigen Schaltung 30 bzw. des Wandlers verbundene Last 5 kann ein LED, eine LED-Strecke mehrere LEDs oder mehrere LED-Strecken umfassen. Die LEDs können in ein LED-Modul integriert sein.

Informationen über die Ausgangsspannung am Ausgang 35 des Wandlers werden basierend auf der in der primärseitigen Schaltung erfassten Spannung V_sns abgeleitet. Die entsprechende Spannung kann beispielsweise die über der Primärspule 28 abfallende Spannung sein. Die in der primärseitigen Schaltung erfasste Spannung V_sns wird der Steuereinrichtung 14 zugeführt. Die in der primärseitigen Schaltung erfasste Spannung V_sns kann A/D-gewandelt werden, bevor sie der Steuereinrichtung 14 zugeführt wird.

Wenn die Schalter in der Halbbrückenschaltung geschaltet werden, klemmen die Gleichrichterdioden 31, 32 auf der Sekundärseite die Spannung an der Sekundärspule auf die Ausgangsspannung, die an der Last 5 anliegt. Entsprechend können aus der Spannung, die beim Schalten der Schalter in der Halbbrückenschaltung an der Primärspule auftritt, Informationen über die Ausgangsspannung am Ausgang 35 abgeleitet werden. Dieses Prinzip wird nach Ausführungsbeispielen verwendet, um eine Ausgangsspannung, die im SELV-Bereich 30 auftritt, durch Messung einer Spannung im nicht-SELV-Bereich 20 zu detektieren. Eine unmittelbare Messung der Ausgangsspannung im SELV-Bereich 30 und Rückführung der gemessenen Spannung über die SELV-Barriere 39 ist nicht erforderlich.

FIG. 3 zeigt schematisch die von der Steuereinrichtung 14 an einen der Schalter 21 oder 22 angelegte Gatespannung 41, mit der der entsprechende Schalter geschaltet wird. Der andere Schalter wird jeweils entgegengesetzt geschaltet. Die Frequenz, mit der die Schalter geschaltet werden, kann beispielsweise zur Regelung der Ausgangsleistung und/oder Ausgangsspannung des Wandlers angepasst werden.

FIG. 3 zeigt auch die Spannung V_sns, wie sie beispielsweise an der Primärspule 28 in der primärseitigen Schaltung 20 erfasst wird. Ein Spannungsverlauf 43 weist eine (positive oder negative) Peakspannung 44 auf, die zeitlich korreliert mit einem Schaltvorgang 42 der Schalter der Halbbrückenschaltung auftritt. Der Peakspannung 44 kann in die Ausgangsspannung umgerechnet werden, um die Ausgangsspannung zu detektieren. Alternativ oder zusätzlich kann die Peakspannung 44 von der Steuereinrichtung 14 automatisch mit vorgegebenen Spannungswerten verglichen werden, um einen offenen Schaltkreis am Ausgang 35, einen Kurzschluss am Ausgang 35 oder die mit dem Ausgang 35 verbundene Last 5 zu erkennen.

Bei einer Änderung der Ausgangsspannung ändert sich auch der Verlauf der Spannung V_sns, die beispielsweise an der Primärspule 28 in der primärseitigen Schaltung 20 erfasst wird. Ein Spannungsverlauf 45, der bei einer andere Last resultieren würde, weist eine (positiven oder negativen) Peakspannung 46 auf, die zeitlich korreliert mit dem Schaltvorgang 42 der Schalter der Halbbrückenschaltung auftritt. Die Peakspannung 46 kann in die Ausgangsspannung umgerechnet werden, um die Ausgangsspannung zu detektieren. Alternativ oder zusätzlich kann die Peakspannung 46 der Steuereinrichtung 14 automatisch mit vorgegebenen Spannungswerten verglichen werden, um einen offenen Zustand am Ausgang 35, einen Kurzschluss am Ausgang 35 oder die mit dem Ausgang 35 verbundene Last 5 zu erkennen. Zur Lasterkennung kann dabei genutzt werden, dass beispielsweise selbst bei einem FCV-Gerät die Ausgangsspannung im realen System immer in einem gewissen Grad mit der Anzahl von LEDs bzw. der Last variiert. Aus der Ausgangsspannung kann somit auf die Anzahl von LEDs bzw. Last rückgeschlossen werden.

Die Steuereinrichtung 14 kann so eingerichtet sein, dass sie die beim Schalten der Schalter der Halbbrückenschaltung auftretende Peakspannung detektiert. Die Steuereinrichtung 14 kann die Peakspannung geeignet weiterverarbeiten, beispielsweise unter Verwendung hinterlegter Formeln, die die Peakspannung V_sns an der Primärspule in die Ausgangsspannung am Ausgang 35 umrechnen, durch Schwellenwertvergleiche zur Erkennung von Fehlerzuständen und/oder durch Verwendung von Kennfeldern, die primärseitig gemessene Spannungswerte in Werte der Ausgangsspannung und/oder Werte der Last übersetzen. Für diese Funktionen kann die Steuereinrichtung 14 entsprechende Logikkomponenten und/oder Speicher umfassen. Die Steuereinrichtung 14 kann als integrierte Halbleiterschaltung ausgestaltet sein, die eine anwendungsspezifische Spezialschaltung sein kann. Die Steuereinrichtung 14 kann insbesondere als ASIC ("Application Specific Integrated Circuit") ausgestaltet sein. Die Steuereinrichtung 14 kann auch als programmierbare Schaltung ausgestaltet sein, die durch Firmware oder Software so programmiert ist, dass sie die primärseitig erfasste Spannung weiter verarbeitet, um daraus Informationen über die Ausgangsspannung zu erhalten.

Verschiedene andere Ausgestaltungen von Wandlern sind möglich, bei denen andere Spannungen in der primärseitigen Schaltung erfasst und/oder ausgewertet werden können, um die Ausgangsspannung zu detektieren.

FIG. 4 ist ein Schaltbild eines Wandlers 49 nach einem weiteren Beispiel. Elemente oder Einrichtungen, die in Ausgestaltung und Funktion Elementen oder Einrichtungen entsprechen, die bereits unter Bezugnahme auf FIG. 1-3 beschrieben wurden, sind mit denselben Bezugszeichen bezeichnet.

Der Wandler 49 weist eine primärseitige Schaltung 50 mit einer getaktet betriebenen Halbbrückenschaltung und einem LLC-Resonanzkreis auf. Der LLC-Resonanzkreis ist als Serienresonanzkreis ausgestaltet, bei dem die Induktivität 26 zwischen die Induktivität 25 und die Kapazität 27 des LLC-Resonanzkreises geschaltet ist.

Bei dem Wandler 49 kann die Spannung V_sns erfasst werden, die über dem Kondensator 27 des LLC-Resonanzkreises in der primärseitigen Schaltung abfällt. Der Peakwert dieser Spannung entspricht dem Peakwert der Spannung, die über der Primärspule 28 abfällt, aber mit umgekehrten Vorzeichen, beziehungsweise dem gleichen Wert und Vorzeichen, wobei dieser mit einer Phasenverschiebung von einer halben Periode erreicht wird. Entsprechend kann aus der Peakspannung am Kondensator 27, die beim Schalten der Schalter der Halbbrückenschaltung auftritt, auf die Ausgangsspannung rückgeschlossen werden.

FIG. 5 ist ein Flussdiagramm eines Verfahrens 60, das von der Steuereinrichtung 14 zum Steuern eines Wandlers durchgeführt werden kann. Der Wandler kann als Wandler nach einem Beispiel ausgestaltet sein. Der Wandler weist einen LLC-Resonanzkreis mit Halbbrückenansteuerung auf. Der Wandler weist eine primärseitige Schaltung und eine davon galvanisch getrennte sekundärseitige Schaltung auf. Die primärseitige Schaltung kann beispielsweise ein nicht-SELV-Bereich des Wandlers sein und die sekundärseitige Schaltung kann der SELV-Bereich des Wandlers sein.

Bei 61 wird eine Spannung in der primärseitigen Schaltung erfasst. Die Spannung kann eine Spannung an einer Primärspule eines Transformators, an einer Induktivität des LLC-Resonanzkreises oder an einer Kapazität des LLC-Resonanzkreises sein.

Bei 62 wird die Peakspannung ermittelt, die beim Schalten von Schaltern der Halbbrücke auftritt. Es kann ein Maximum oder Minimum der erfassten Spannung ermittelt werden, das zeitlich korreliert mit dem Schalten von Schaltern der Halbbrücke auftritt.

Bei 63 wird de Spannung weiter verarbeitet, um Informationen über die Ausgangsspannung der sekundärseitigen Schaltung des Wandlers zu erhalten. Dazu kann beispielsweise überprüft werden, ob am Ausgang der sekundärseitigen Schaltung eine offene Schaltung oder ein Kurzschluss vorliegt. Dazu kann überprüft werden, ob die primärseitig erfasste Peakspannung in einem Intervall zulässiger Spannungswerte liegt. Falls weder eine offene Schaltung noch ein Kurzschluss am Ausgang der sekundärseitigen Schaltung vorliegt, kann bei 64 eine Last bestimmt werden, die mit dem Ausgang gekoppelt ist. Dazu kann beispielsweise die Anzahl von LEDs abgeschätzt werden, die mit dem Wandler gekoppelt ist und von diesem mit Energie versorgt wird. Die Informationen über die Last kann beispielsweise bei einer Spannungsregelung verwendet werden. Falls bei 63 erkannt wird, dass ein Kurzschluss am Ausgang der sekundärseitigen Schaltung vorliegt, kann bei 65 ein Fehlermanagement eingeleitet werden. Das Fehlermanagement kann die Ausgabe eines entsprechenden optischen, akustischen oder elektronischen Signals, das den Fehler anzeigt, und/oder eine Sicherheitsabschaltung umfassen.

Weitere Verfahrensschritte können vorgesehen sein. Beispielsweise kann das Ermitteln der Peakspannung, die beim Schalten von Schaltern der Halbbrücke auftritt, zyklisch wiederholt werden. Die Ausgangsspannung kann geregelt werden, wobei die primärseitig erfasste Peakspannung als Eingangssignal für die Regelung verwendet wird. Zur Regelung kann die Frequenz, mit der die Schalter der Halbbrücke geschaltet werden, als Stellgröße des Regelkreises geändert werden.

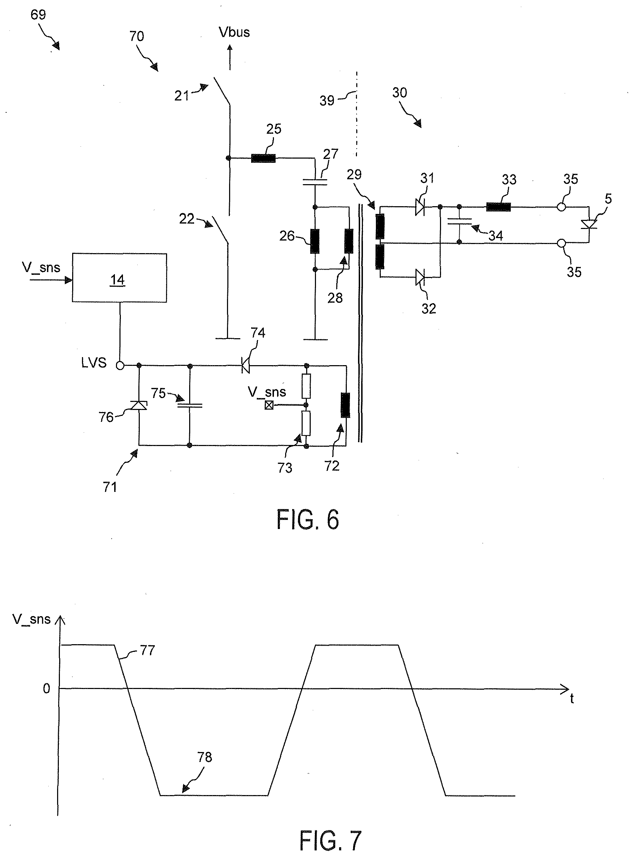

Die Erfassung der Spannung im nicht-SELV-Bereich des Wandlers, die mit der Ausgangsspannung des SELV-Bereichs korreliert ist, kann an weiteren Schaltungselementen durchgeführt werden. Beispielsweise kann, wie unter Bezugnahme auf FIG. 6-9 beschrieben wird, die Spannung, die Informationen über die Ausgangsspannung des Wandlers liefert, in einer Versorgungsschaltung abgegriffen werden, die eine Versorgungsspannung für die Steuereinrichtung 14 liefert.

FIG. 6 ist ein Schaltbild eines Wandlers 69 nach einem weiteren Beispiel. Elemente oder Einrichtungen, die in Ausgestaltung und Funktion Elementen oder Einrichtungen entsprechen, die bereits unter Bezugnahme auf FIG. 1-5 beschrieben wurden, sind mit denselben Bezugszeichen bezeichnet.

Der Wandler 69 weist eine primärseitige Schaltung 70 mit einer getaktet betriebenen Halbbrückenschaltung und einem LLC-Resonanzkreis auf. Weiterhin ist eine Versorgungsschaltung 71 vorgesehen, um die Versorgungsspannung für die Steuereinrichtung 14 bereitzustellen. Die Versorgungsschaltung 71 ist zwischen den Transformator mit der Primärspule 28 und der Sekundärspule 29 und einen Versorgungsanschluss der Steuereinrichtung 14 geschaltet. Die in der Versorgungsschaltung 71 auftretenden Spannungen können kleiner als die Versorgungsspannung Vbus der primärseitigen Schaltung, insbesondere viel kleiner als die Versorgungsspannung Vbus der primärseitigen Schaltung sein. Die Versorgungsschaltung 71 ist im nicht-SELV-Bereich des Wandlers vorgesehen, d.h. von der sekundärseitigen Schaltung 30 durch die SELV-Barriere getrennt sein.

Die Versorgungsschaltung 71 weist wenigstens eine Versorgungswicklung 72 oder eine Versorgungsspule 72 mit mehreren Wicklungen auf, die auf demselben Transformatorkern sitzt, auf dem auch die Primärspule 28 und die Sekundärspule 29 sitzen. Die wenigstens eine Versorgungswicklung 72 oder Versorgungsspule 72 kann so ausgestaltet sein, dass die von der Versorgungsschaltung 71 bereitgestellte Versorgungsspannung für die Steuereinrichtung 14 im Niederspannungsbereich liegt, beispielsweise bei ungefähr 5 Volt. Über eine Diode 74 wird ein Ladekondensator 75 geladen. Eine Zenerdiode 76 kann vorgesehen sein, um die von der Versorgungsschaltung 71 bereitgestellte Spannung zu stabilisieren bzw. zu begrenzen.

Da die wenigstens eine Versorgungswicklung 72 oder Versorgungsspule 72 auf demselben Transformatorkern sitzt wie die Sekundärspule 29, kann abhängig von einer Spannung an der wenigstens einen Versorgungswicklung 72 oder Versorgungsspule 72, die beim Schalten der Schalter der Halbbrücke auftritt, auf die Ausgangsspannung am Ausgang 35 der sekundärseitigen Schaltung 30 rückgeschlossen werden. Die Spannung V_sns, die im nicht-SELV-Bereich erfasst wird, kann über einen Spannungsteiler 73 an der wenigstens einen Versorgungswicklung 72 oder Versorgungsspule 72 abgegriffen werden. Diese Spannung V_sns kann der Steuereinrichtung 14 zugeführt werden. Die Spannung V_sns kann A/D-gewandelt werden, bevor sie der Steuereinrichtung 14 zugeführt wird. Die Steuereinrichtung 14 kann die Spannung V_sns verarbeiten, um abhängig von einer Peakspannung, die beim Schalten von Schaltern der Halbbrücke auftritt, Informationen über die Ausgangsspannung der sekundärseitigen Schaltung 30 abzuleiten.

FIG. 7 zeigt schematisch einen typischen zeitlichen Verlauf 77 der primärseitig erfassten Spannung V_sns, wie sie bei dem Wandler 69 von FIG. 6 abgegriffen wird. Eine negative Peakspannung 78, die beim Schalten von Schaltern der Halbbrücke auftritt, ist mit der Ausgangsspannung der sekundärseitigen Schaltung 30 korreliert. Die Peakspannung 78 kann von der Steuereinrichtung 14 rechnerisch weiter verarbeitet werden.

Da eine genaue Messung der Peakspannung 78, die einer negativen Spannung entsprechen kann, schwierig sein kann, kann die gemessene Spannung um einen Spannungs-Offset verschoben werden. Dazu kann in der Versorgungsschaltung ein Konstantstrom und ein zusätzlicher Widerstand verwendet werden.

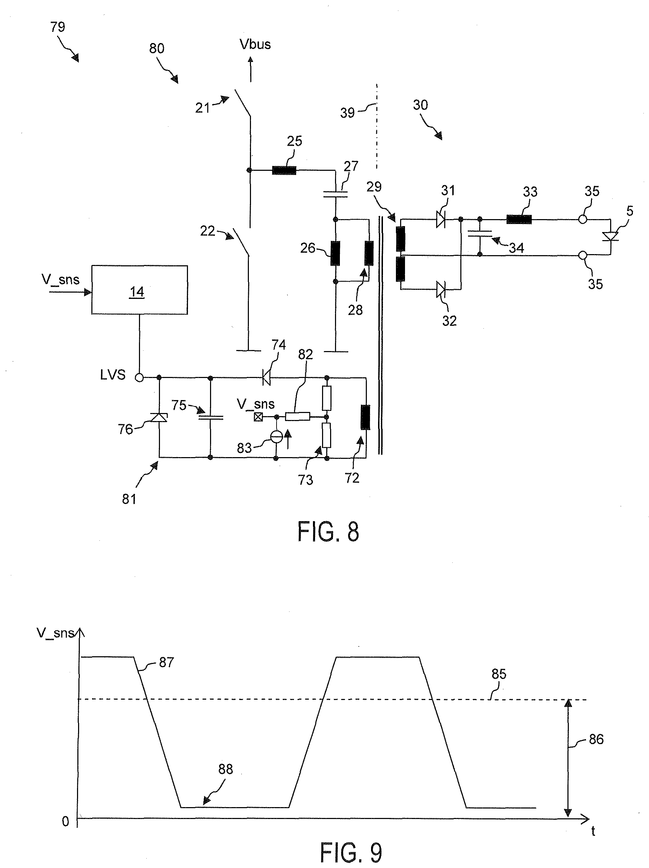

FIG. 8 ist ein Schaltbild eines Wandlers 79 nach einem weiteren Beispiel. Elemente oder Einrichtungen, die in Ausgestaltung und Funktion Elementen oder Einrichtungen entsprechen, die bereits unter Bezugnahme auf FIG. 1-7 beschrieben wurden, sind mit denselben Bezugszeichen bezeichnet.

Der Wandler 79 weist eine primärseitige Schaltung 80 mit einer getaktet betriebenen Halbbrückenschaltung und einem LLC-Resonanzkreis auf. Weiterhin ist eine Versorgungsschaltung 81 vorgesehen, um die Versorgungsspannung für die Steuereinrichtung 14 bereitzustellen. Die Versorgungsschaltung 81 ist grundsätzlich wie unter Bezugnahme auf FIG. 6 beschrieben ausgestaltet.

Um die abgetastete Spannung V_sns um einen Spannungs-Offset zu verschieben, weist die Versorgungsschaltung 81 einen weiteren Widerstand 82, der mit dem Spannungsteiler 73 verbunden ist, und einen Konstantstrom auf. Eine entsprechende Konstantstromquelle 83 ist schematisch dargestellt. Bei Ausführungsbeispielen muss keine separate Konstantstromquelle vorgesehen sein, sondern ein Anschlussstift der Steuereinrichtung 14 kann den Konstantstrom liefern. Somit kann die Steuereinrichtung 14 auch die Funktion der Konstantstromquelle 83 erfüllen.

Durch die Konstantstromquelle 83 und den Widerstand 82 wird die auf der nicht-SELV-Seite des Wandlers 79 abgetastete Spannung V_sns um ein Spannungs-Offset in den positiven Bereich verschoben. Der Spannungs-Offset kann so groß gewählt sein, dass die beim Schaltvorgang der Schalter in der Halbbrücke auftretende Spannung in den positiven Spannungsbereich verschoben wird. Dies kann durch entsprechende Wahl des von der Konstantstromquelle 83 gelieferten Stroms und des Widerstands 82 erreicht werden.

FIG. 9 zeigt schematisch einen typischen zeitlichen Verlauf 87 der Spannung V_sns, wie sie bei dem Wandler 79 von FIG. 8 abgegriffen wird. Durch die Konstantstromquelle 83 und den Widerstand 82 wird die Basislinie 85 um ein Spannungs-Offset 86 verschoben. Eine negative Peakspannung, die beim Schalten von Schaltern der Halbbrücke auftritt, wird durch den Spannungs-Offset zu positiven Spannungen verschoben. Durch Messung der Spannung 88, die beim Schalten der Schalter der Halbbrücke detektiert wird, und basierend auf dem bekannten Spannungs-Offset 86 kann die Steuereinrichtung 14 die negative Peakspannung an der Versorgungsspule 72 ermitteln, die beim Schalten der Schalter der Halbbrücke detektiert wird. Diese steht, wie erläutert, in einer direkten Beziehung zur Ausgangsspannung am Ausgang 35 der sekundärseitigen Schaltung 30.

Unter Bezugnahem auf FIG. 6-9 wurden Wandler beschrieben, bei denen eine Niederspannungsversorgung der Steuereinrichtung 14 durch die Versorgungsschaltung 71 bzw. 81 mit einer Spannungserfassung im nicht-SELV-Bereich kombiniert wird, um Informationen über die Ausgangsspannung am Ausgang der sekundärseitigen Schaltung 30 zu gewinnen. Eine derartige Versorgungsschaltung für die Steuereinrichtung 14 kann jedoch auch verwendet werden, wenn die Ausgangsspannung nicht primärseitig erfasst werden soll. Eine derartige Versorgungsschaltung, bei der die Versorgungsspannung für die Steuereinrichtung 14 über die Versorgungswicklung(en) 72 bzw. Versorgungsspule 72 auf dem Transformatorkern erzeugt wird, kann im Vergleich zu herkömmlichen Ansätzen Vorteile im Hinblick auf die Leistungsverluste bieten.

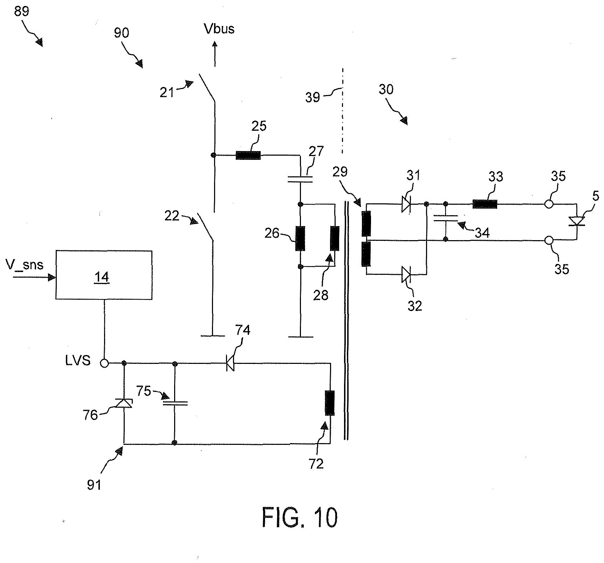

FIG. 10 zeigt einen Wandler 89 nach einem weiteren Beispiel. Elemente oder Einrichtungen, die in Ausgestaltung und Funktion Elementen oder Einrichtungen entsprechen, die bereits unter Bezugnahme auf FIG. 1-9 beschrieben wurden, sind mit denselben Bezugszeichen bezeichnet.

Der Wandler 89 weist eine primärseitige Schaltung 90 mit einer getaktet betriebenen Halbbrückenschaltung und einem LLC-Resonanzkreis auf. Es ist eine Versorgungsschaltung 91 vorgesehen, um die Versorgungsspannung für die Steuereinrichtung 14 bereitzustellen. Die Versorgungsschaltung 91 ist zwischen den Transformator mit der Primärspule 28 und der Sekundärspule 29 und einen Versorgungsanschluss der Steuereinrichtung 14 geschaltet. Die Ausgangsspannung der Versorgungsschaltung 91 kann kleiner, insbesondere viel kleiner, als die Versorgungsspannung Vbus der primärseitigen Schaltung sein. Die Versorgungsschaltung 91 kann im nicht-SELV-Bereich des Wandlers vorgesehen sein, d.h. von der sekundärseitigen Schaltung 30 durch die SELV-Barriere getrennt sein. Die Versorgungsschaltung 91 weist wenigstens eine Versorgungswicklung 72 oder eine Versorgungsspule 72 mit mehreren Wicklungen auf, die auf demselben Transformatorkern sitzt, auf dem auch die Primärspule 28 und die Sekundärspule 29 sitzen. Die wenigstens eine Versorgungswicklung 72 oder Versorgungsspule 72 kann so ausgestaltet sein, dass die von der Versorgungsschaltung 91 bereitgestellte Versorgungsspannung für die Steuereinrichtung 14 im Niederspannungsbereich liegt, beispielsweise bei ungefähr 5 Volt. Über eine Diode 74 wird ein Ladekondensator 75 geladen. Eine Zenerdiode 76 kann vorgesehen sein, um die von der Versorgungsschaltung 91 bereitgestellte Spannung zu stabilisieren bzw. zu begrenzen.

Bei dem Wandler 89 von FIG. 10 kann primärseitig eine Spannung abgetastet werden, die von der Ausgangsspannung der sekundärseitigen Schaltung 35 abhängt, ohne dass dies zwingend erforderlich ist. Bei weiteren Beispielen kann der Wandler 89, der die zwischen Transformator und Versorgungsanschluss der Steuereinrichtung 14 geschaltete Versorgungsschaltung 91 aufweist, auch andere Resonanzkreise als den LLC-Serienresonanzkreis umfassen, oder es muss gar kein Resonanzkreis vorgesehen sein. Eine Versorgungsschaltung 91, wie sie in FIG. 10 dargestellt ist, kann grundsätzlich bei Wandlern für Leuchtmittel verwendet werden, bei denen ein Transformator für eine galvanische Trennung von primärer und sekundärer Seite realisiert.

Während Beispiele unter Bezugnahme auf die Figuren beschrieben wurden, können Abwandlungen bei weiteren Beispielen realisiert werden. Während die Peakspannung, die beim Schalten der Schalter der Halbbrücke an einer Primärspule des Transformators auftritt, als Indikator für die Ausgangsspannung der sekundärseitigen Schaltung verwendet werden kann, kann eine entsprechende primärseitige Erfassung einer Spannung, die Indikator für die Ausgangsspannung der sekundärseitigen Schaltung verwendet werden kann, auch an anderen Elementen der primärseitigen Schaltung durchgeführt werden.

Induktivitäten und Kapazitäten können jeweils durch entsprechende induktive bzw. kapazitive Elemente, beispielsweise als Spulen bzw. Kondensatoren, gebildet werden. Es ist jedoch auch möglich, dass kleinere Induktivitäten, beispielsweise die kleinere Induktivität des LLC-Resonanzkreises, als Streuinduktivität ausgebildet sind. Ähnlich können kleinere Kapazitäten als Streukapazitäten ausgebildet sein.

Während eine der Spulen des LLC-Resonanzkreises in einer Parallelschaltung mit einer Primärspule des Transformators vorgesehen sein kann, kann bei weiteren Ausführungsbeispielen die Primärspule des Transformators auch als eine der Induktivitäten des LLC-Resonanzkreises wirken.

Wandler und Verfahren nach Ausführung und Beispielen können insbesondere zur Energieversorgung von LEDs eingesetzt werden.

## Patentansprüche

1. Verfahren zur Bestimmung der Streuinduktivität eines Transformators (28, 29) eines LLC-Resonanzwandlers (19; 49; 69; 79; 89) für ein Leuchtmittel (3; 5),
wobei der LLC-Resonanzwandler (19; 49; 69; 79; 89) eine primärseitige Schaltung (20; 50; 70; 80; 90) und eine davon galvanisch getrennte sekundärseitige Schaltung (30) aufweist,
wobei der Transformator eine Primärspule (28) und eine Sekundärspule (29) aufweist,
wobei die primärseitige Schaltung (20; 50; 70; 80; 90) des LLC-Resonanzwandlers (19; 49; 69; 79; 89) eine mit dem Transformator (28, 29) verbundene LLC-Resonanzschaltung und eine mit der LLC-Resonanzschaltung verbundene Halbbrückenschaltung (21, 22) aufweist,
wobei das Verfahren umfasst:
a) Aus dem Ruhezustand des LLC-Resonanzwandlers (19; 49; 69; 79; 89) heraus, Einschalten eines ersten Schalters (21) der Halbbrückenschaltung (21, 22);
b) Erfassen einer Spannung an einem Messwiderstand (Rs) in Serie zu der Primärspule (28) des Transformators (28, 29); und
c) Verarbeiten, in einer Steuereinrichtung (14), der erfassten Spannung,
wobei das Verarbeiten ein Erfassen eines Anstiegs der erfassten Spannung über eine Zeitspanne umfasst, die von dem Überschreiten (start) einer unteren Referenzspannung (Vrefu) bis zum Erreichen (stop) einer oberen Referenzspannung (Vrefo) zur Bestimmung der Streuinduktivität ausgewertet wird.

## Claims

1. A method for determining the leakage inductance of a transformer (28, 29) of an LLC resonant converter (19; 49; 69; 79; 89) for a lighting means (3; 5),
wherein the LLC resonant converter (19; 49; 69; 79; 89) has a primary-side circuit (20; 50; 70; 80; 90) and a secondary-side circuit (30) that is galvanically separated therefrom,
wherein the transformer has a primary coil (28) and a secondary coil (29),
wherein the primary-side circuit (20; 50; 70; 80; 90) of the LLC resonant converter (19; 49; 69; 79; 89) has an LLC resonant circuit connected to the transformer (28, 29) and a half-bridge circuit (21, 22) connected to the LLC resonant circuit,
wherein the method comprises:
a) Out of the rest state of the LLC resonant converter (19; 49; 69; 79; 89) activation of a first switch (21) of the half-bridge circuit (21, 22);
b) Detection of a voltage at a measurement resistor (Rₛ) in series with the primary coil (28) of the transformer (28, 29);
c) Processing, in a control device (14), of the detected voltage,
wherein the processing comprises a detection of an increase in the detected voltage over a time period,
which from the exceeding (start) of a lower reference voltage (Vrefu) to the reaching (stop) of an upper reference voltage (Vrefo) is evaluated for determining the leakage inductance.

## Revendications

1. Procédé pour la détermination de l'inductance de fuite d'un transformateur (28, 29) d'un convertisseur à résonance LLC (19 ; 49 ; 69 ; 79 ; 89) pour un moyen d'éclairage (3 ; 5),
le convertisseur à résonance LLC (19 ; 49 ; 69 ; 79 ; 89) comprenant un circuit côté primaire (20 ; 50 ; 70 ; 80 ; 90) et un circuit côté secondaire (30) isolé galvaniquement de celui-ci,
le transformateur comprenant une bobine primaire (28) et une bobine secondaire (29),
le circuit côté primaire (20 ; 50 ; 70 ; 80 ; 90) du convertisseur à résonance LLC (19 ; 49 ; 69 ; 79 ; 89) comprenant un circuit à résonance LLC relié avec le transformateur (28, 29) et un circuit en demi-pont (21, 22) relié avec le circuit à résonance LLC,
le procédé comprenant :
a) à partir de l'état de repos du convertisseur à résonance LLC (19 ; 49 ; 69 ; 79 ; 89), mise en marche d'un premier commutateur (21) du circuit en demi-pont (21, 22) ;
b) mesure d'une tension au niveau d'une résistance de mesure (Rs) en série avec la bobine primaire (28) du transformateur (28, 29) ; et
c) traitement, dans un dispositif de commande (14), de la tension mesurée, le traitement comprenant une mesure d'une augmentation de la tension mesurée sur une période, qui est analysée à partir du dépassement (start) d'une tension de référence inférieure (Vrefu) jusqu'à ce qu'elle atteigne (stop) une tension de référence supérieure (vrefo) pour la détermination de l'inductance de fuite.
